# EUROPÄISCHE PATENTSCHRIFT

(11) **EP 2 633 547 B1**
(45) Veröffentlichungstag und Bekanntmachung des Hinweises auf die Patenterteilung: **10.12.2014**
(21) Anmeldenummer: 10771031.1
(22) Anmeldetag: 26.10.2010
(51) Int. Cl.: H01L 21/67, H01L 21/68, G01B 11/00

(54) **VERFAHREN ZUR BESTIMMUNG DER POSITION EINER ROTATIONSACHSE**
METHOD FOR DETERMINING THE POSITION OF A ROTATION AXIS
PROCÉDÉ DE DÉTERMINATION DE LA POSITION D'UN AXE DE ROTATION

(43) Veröffentlichungstag der Anmeldung: 04.09.2013
(73) Patentinhaber: Ev Group E. Thallner GmbH, 4782 St. Florian am Inn (AT)
(72) Erfinder: WAGENLEITNER, Thomas, A-4971 Aurolzmünster (AT)
(74) Vertreter: Schweiger, Johannes
(86) Internationale Anmeldenummer: PCT/EP2010/006517
(87) Internationale Veröffentlichungsnummer: WO 2012/065615

(56) Entgegenhaltungen:
- EP-A1- 1 564 804
- EP-A1- 1 886 771
- JP-A- 2003 318 249
- US-A1- 2005 016 818
- US-A1- 2006 023 214
- US-A1- 2007 020 871

## Beschreibung

Die Erfindung betrifft ein Verfahren zur Bestimmung eines Ausrichtungsfehlers einer Vielzahl von auf zwei gegenüberliegenden Seiten eines Substrats angeordneten, jeweils zueinander ausgerichteten Kontaktstellen gemäß Anspruch 1.

Ein verwandtes Verfahren zur Bestimmung eines Ausrichtungsfehlers ist etwa in US 2005/016818 gezeigt.

Wegen immer stärkerer Miniaturisierung von Halbleiterbauelementen werden diese künftig verstärkt in gestapelter Form verbaut, so dass ein Bedarf für optimierte Verfahren zur Herstellung solcher gestapelten Halbleiterprodukte besteht. Ein Verfahren, um Halbleiterbauelemente vertikal zu stapeln, besteht unter anderem darin, einen Wafer doppelseitig mit Halbleiterbauelementen, insbesondere Dices und/oder Chips, doppelseitig zu bestücken. Auf beiden Seiten des Wafers befindet sich daher eine Vielzahl von Halbleiterbauelementen, die in weiteren Prozessschritten mit korrespondierenden, jeweils beidseitig mit Halbleiterbauelementen bestückten Wafern über Kontaktstellen verbunden werden. Wegen der immer kleiner werdenden Bauelemente, insbesondere Dices und/oder Chips, ist es von entscheidender Bedeutung, dass die korrespondierenden Kontaktstellen der Halbleiterbauelemente möglichst genau miteinander fluchten, also vertikal zueinander ausgerichtet sind. Bei einer ungenauen Ausrichtung oder Verschiebung der Halbleiterbauelemente, insbesondere der Kontaktstellen der Halbleiterbauelemente auf den gegenüberliegenden Seiten der Wafer, würden die korrespondierenden Kontakte nicht oder nicht ausreichend miteinander verbunden werden. Aus diesem Grund findet eine Überprüfung der Position von Kontaktstellen auf der Ober- und Unterseite jedes Wafers statt.

Da eine Vielzahl von Kontaktstellen auf jedem Wafer zu prüfen ist und insbesondere die Ausrichtung jeder Kontaktstelle mit der jeweils gegenüberliegenden Kontaktstelle relevant ist, ist diese Überprüfung zeitaufwendig und entsprechend teuer.

Zur Bestimmung des Ausrichtungsfehlers von gegenüberliegenden Kontaktstellen hat es sich bewährt, die Position jeder Kontaktstelle auf jeder Substratseite in einer ersten Rotationsposition des Substrats und in einer zweiten Rotationsposition, die gegenüber der ersten um 180 Grad gedreht ist, zu erfassen. Die, dabei durchgeführte Rotation um 180 Grad bewirkt, dass Meßungenauigkeiten induziert durch die optischen Positionserfassungsmittel aus dem Messergebnis gefiltert, quasi herausgekürzt werden. Hierbei besteht das technische Problem, dass nach Rotation des Substrats zunächst die neue Position mit dem als Erfassungsmittel dienenden Objektiv grob angefahren werden muss (sogenanntes Pre-Alignment).

Es stellt sich daher die Aufgabe, ein Verfahren zu entwickeln, mit welchem die vorgenannten technischen Probleme gelöst werden können, so dass eine schnellere und entsprechend kostengünstigere Bestimmung des Aufrichtungsfehlers von jeweils zueinander ausgerichteten Kontaktstellen ermöglicht werden kann.

Diese Aufgabe wird mit den Merkmalen des Anspruchs 1 gelöst. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Figuren angegebenen Merkmalen. Bei angegebenen Wertbereichen sollen auch innerhalb der genannten Grenzen liegende Werte als Grenzwerte offenbart und in beliebiger Kombination beanspruchbar sein.

Der vorliegenden Erfindung liegt der Gedanke zugrunde, einen neuen Ansatz zu wählen, indem vor der Bestimmung der Ausrichtungsfehler der Kontaktstellen des Substrates einmalig dessen Rotationsachse beziehungsweise die Rotationsachse einer Substrataufnahme zur Aufnahme des Substrats bestimmt wird, um mittels der sich nicht ändernden genauen Position der Rotationsachse des Substrats beziehungsweise der das Substrat aufnehmenden Substrataufnahme auf die jeweils gegenüberliegende Position der Kontaktstelle für die Messung in der zweiten Rotationslage rückschließen zu können.

Somit wird erfindungsgemäß auf das zeitaufwendige Pre-Alignment an jeder Kontaktstelle verzichtet, wodurch die Bestimmung des Ausrichtungsfehlers der jeweils zueinander ausgerichteten Kontaktstellen um ein vielfaches beschleunigt wird. Besonders vorteilhaft ist es dabei, dass die Rotation jedes Substrats nur einmal erfolgen muss, wenn zunächst die X-Y-Positionen der Kontaktstellen in einer ersten Rotationslage des Substrats/der Substrataufnahme erfasst werden und anschließend, also nach einmaliger Rotation des Substrats durch die Substrataufnahme, die korrespondierenden X-Y-Positionen der Kontaktstellen in einer zweiten Rotationslage erfasst werden.

Beim bisher erforderlichen Pre-Alignment musste nach der Rotation zunächst die entsprechend zu vermessende Kontaktstelle der einen Seite wieder in den Erfassungsbereich der optischen Erfassungsmittel gebracht und dort zentriert werden, bevor an der gegenüberliegenden Seite des Substrats die Position der korrespondierenden Kontaktstelle der gegenüberliegenden Seite bestimmt werden konnte.

Erfindungsgemäß wird das Pre-Alignment durch eine Berechnung der Position der Kontaktstelle nach der Rotation aufgrund der bekannten Position der Rotationsachse ersetzt. Als Referenzmarkierung zur Bestimmung der Position der Rotationsachse kann eine speziell hierfür am Substrat oder an der Substrataufnahme vorgesehene, optisch erfassbare Markierung vorgesehen sein oder eine auf dem Substrat vorhandene Struktur, insbesondere eine Kontaktstelle, verwendet werden.

Gemäß einer vorteilhaften Ausführungsform der Erfindung ist vorgesehen, dass die Rotation des Substrats um die Rotationsachse mit einem vorgegebenen Rotationswinkel R durch eine Substrataufnahme erfolgt, wobei die Substrataufnahme das Substrat, insbesondere an dessen Umfang, unterstützend ausgebildet ist, vorzugsweise in Form eines Rings, so dass die Kontaktstellen an der Unterseite des Substrats durch die Ringöffnung hindurch von unten zugänglich bleiben. Besonders vorteilhaft und zur genauestmöglichen Bestimmung der Position der Rotationsachse geeignet ist es, wenn die Referenzmarkierung am oder auf dem Ring der Substrataufnahme angeordnet ist. Dies insbesondere deshalb, weil das Substrat auf der Substrataufnahme während der Bestimmung der X-Y-Position der Rotationsachse sowie während der Bestimmung des Ausrichtungsfehlers der Vielzahl von gegenüberliegenden Kontaktstellen fixiert ist. Damit ist die X-Y-Position der Referenzmarkierung bei jedem neuen Substrat schon vorher bekannt und es ist nur noch die X-Y-Position der Rotationsachse zu bestimmen, ohne nach der Position der Referenzmarkierung auf dem Substrat suchen zu müssen.

Gemäß einer weiteren vorteilhaften Ausführungsform der Erfindung ist vorgesehen, dass die Bestimmung der ersten und zweiten Referenzposition durch optische Positionserfassungsmittel, insbesondere ein Objektiv umfassend, vorzugsweise mit einer optischen Achse parallel zur Rotationsachse R, erfolgt. Insbesondere bei digitaler Ausgestaltung der optischen Positionserfassungsmittel kann die Erfassung digital erfolgen, so dass die Position der Rotationsachse R in elektronischer Form durch eine entsprechende Datenverarbeitungseinrichtung berechnet wird.

Soweit die Substrataufnahme relativ zu den optischen Positionserfassungsmitteln entlang des X-Y-Koordinatensystems bewegbar ist, wobei die Relativbewegung in das X-Y-Koordinatensystem aufspannender X-Richtung und Y-Richtung erfassbar ist, wird die Berechnung der Positionen der Referenzmarkierung und entsprechend der Rotationsachse, insbesondere bei Verwendung eines kartesischen Koordinatensystems, stark vereinfacht.

Somit ist in Weiterbildung und Verwendung des oben beschriebenen Verfahrens ein Verfahren zur Bestimmung eines Ausrichtungsfehlers einer Vielzahl von auf zwei gegenüberliegenden Seiten eines Substrats angeordneten, zueinander ausgerichteten Kontaktstellen erfindungsgemäß realisierbar, da es folgenden Ablauf umfasst:
- Aufbringung des Substrats auf eine entlang eines X-Y-Koordinatensystems bewegbare und um eine senkrecht zum X-Y-Koordinatensystem liegende Rotationsachse rotierbare Substrataufnahme,
- Bestimmung der Position der Rotationsachse mit den oben beschriebenen Schritten vor oder nach Aufbringung des Substrats auf die Substrataufnahme und
- Bestimmung des Ausrichtungsfehlers der jeweils zueinander ausgerichteten Kontaktstellen.

Besonders vorteilhaft ist es dabei, wenn die Bestimmung des Ausrichtungsfehlers durch die optischen Erfassungsmittel erfolgt. Somit können die optischen Positionserfassungsmittel gleichzeitig für mehrere Aufgaben eingesetzt werden. Während bei der Bestimmung der Position der Rotationsachse ein einziges Objektiv zur Verwirklichung der Erfindung ausreicht, sind bei der Bestimmung des Ausrichtungsfehlers mindestens, insbesondere genau, zwei Objektive von Vorteil, nämlich eines oberhalb des Substrats zur Bestimmung der X-Y-Positionen der Kontaktstellen auf der Oberseite des Substrats und das zweite unterhalb des Substrats zur Bestimmung der X-Y-Positionen der Kontaktstellen auf der Unterseite des Substrats.

Indem die Bestimmung des Ausrichtungsfehlers in einer ersten Rotationslage und einer, gegenüber der ersten Rotationslage um einen Rotationswinkel um die Rotationsachse R rotierten zweiten Rotationslage des Substrats erfolgt, wird die Bestimmung des Ausrichtungsfehlers in besonders einfacher und schneller und somit kostengünstiger Art und Weise ermöglicht.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen:
- Fig. 1a:: eine schematische Querschnittsansicht eines Substrats mit korrekt ausgerichteten Kontaktstellen,
- Fig. 1b:: eine schematische Querschnittsansicht eines Substrats mit nicht korrekt ausgerichteten Kontaktstellen,
- Fig. 2a:: eine schematische Aufsicht auf ein Substrat gemäß Figur 1a,
- Fig. 2b:: eine schematische Aufsicht auf ein Substrat gemäß Figur 1b,
- Fig. 3a:: eine schematische Querschnittsansicht auf Teile einer Vorrichtung zur Ausübung eines erfindungsgemäßen Verfahrens zur Bestimmung der Position einer Rotationsachse,
- Fig. 3b:: eine schematische Detailansicht eines Details gemäß Figur 3a,
- Fig. 4a - 4e:: eine schematische Darstellung des erfindungsgemäßen Verfahrens zur Bestimmung der Position einer Rotationsachse aus einer Y-Richtung,
- Fig. 5a - 5e:: eine schematische Darstellung des erfindungsgemäßen Verfahrens gemäß Figuren 4a - 4e aus einer X-Richtung und
- Fig. 6a - 6d:: eine schematische Darstellung des erfindungsgemäßen Verfahrens zur Bestimmung des Ausrichtungsfehlers in einer Aufsicht.

In den Figuren sind gleiche Bauteile und Bauteile mit der gleichen Funktion mit den gleichen Bezugszeichen gekennzeichnet.

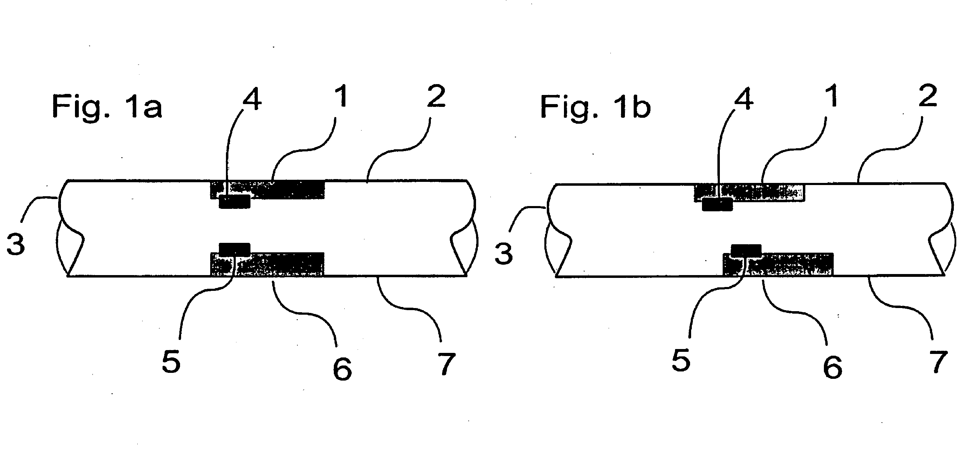

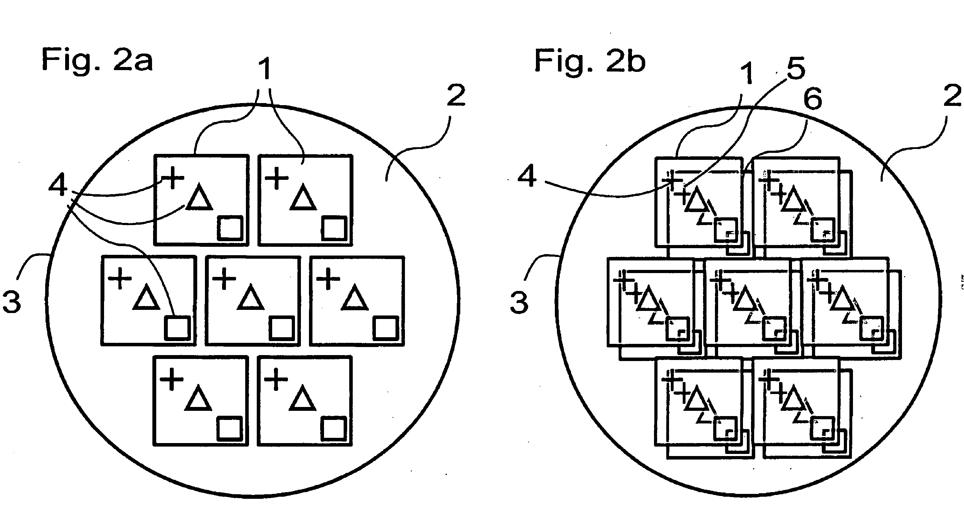

In den Figuren 1a und 1b ist jeweils ein Ausschnitt eines Wafers 3 als Substrat gezeigt, der - wie auch in den Figuren 2a und 2b zu erkennen - eine Vielzahl von Halbleiterbauelementen 1 an einer Oberseite 2 des Wafers 3 und eine Vielzahl von Halbleiterelementen 6 an einer Unterseite 7 des Wafers 3 aufweist.

Jedes Halbleiterbauelement 1, 6, hier ausgebildet als Dices 1, 6, weist mehrere Kontaktstellen 4, 5 auf und die jeweils korrespondierenden Kontaktstellen 4 und 5 sollen, wie in Figur 1a und Figur 2a gezeigt, genau zueinander in Flucht ausgerichtet sein. In den Figuren 1b und 2b sind die Kontaktstellen 4 und 5 und die Dices 1 und 6 nicht korrekt ausgerichtet, so dass ein solcher Wafer 3 Ausschuss ist oder nochmals zumindest einseitig bestückt werden muss.

In den Figuren sind die Dices und die Kontaktstellen stark vergrößert dargestellt und ein Wafer mit 300mm Durchmesser weist mehrere 100 Dices 1, 6 mit jeweils mehreren Kontaktstellen 4, 5 auf, die hier der Anschaulichkeit halber nur schematisch dargestellt sind. Jeder Dice 1, 6 besitzt funktionelle Halbleiterbauelemente, deren Kontaktstellen 4, 5 durch Kreuze, Dreiecke, und Rechtecke schematisch symbolisiert worden sind. Die funktionalen Baugruppen der Dices 1 auf der Oberseite 2 müssen mit den funktionalen Bauteilen der Dices 6 auf der Unterseite 7 nicht übereinstimmen, die Kontaktstellen 4, 5 der korrespondierenden Halbleiterbauelemente 1, 6 sind jedoch deckungsgleich.

Wird ein Fehler gemäß Figuren 1b und 2b entdeckt und ist die Abweichung der Kontaktstellen 4, 5 zu groß, um eine erfolgreiche vertikale Kontaktierung zu erreichen, wird der Wafer 3 aus dem Produktionsprozess genommen und kann auf der Oberseite 2 oder der Unterseite 7 gereinigt und erneut lithografisch behandelt werden, nachdem der Fehler im System ermittelt wurde.

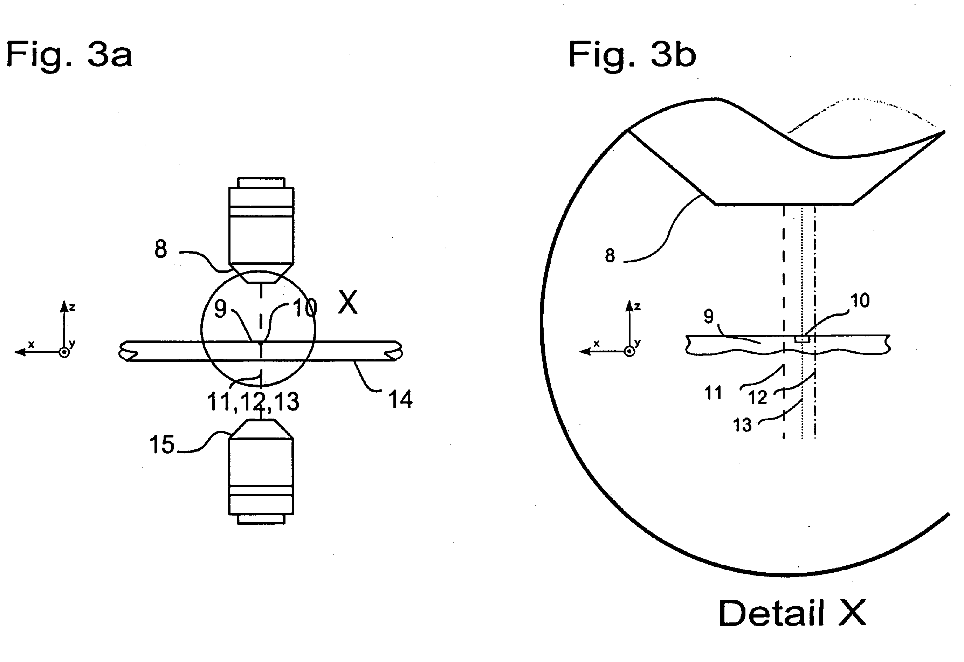

In Figur 3a und der Detailansicht gemäß Figur 3b ist eine Substrataufnahme 14 zur Aufnahme des Wafers 3 auf einer Oberfläche 9 der Substrataufnahme 14 gezeigt, die in Form eines Rings sowohl den Zugang zu der Oberseite 2 des Wafers 3 als auch zu dessen Unterseite 7 zulässt, sobald der Wafer 3 auf die Substrataufnahme 14 aufgebracht worden ist und indem sie den Wafer 3 an dessen Seitenrand abstützt. Der Wafer 3 ist auf der Substrataufnahme 14 fixierbar und die Substrataufnahme 14 ist in dem in Figur 3a dargestellten kartesischen X-Y-Koordinatensystem in der durch die Pfeile X und Y vorgegebenen X- und Y-Richtung translatorisch bewegbar, insbesondere angetrieben durch Linearmotoren mit einer genauen Steuerung der Bewegung in X- und Y-Richtung. Gleichzeitig ist die Substrataufnahme 14 um eine Rotationsachse 12 rotierbar. Das X-Y-Koordinatensystem ist mit Vorteil fix bezogen auf das Objektiv 8. Die Rotationsachse 12 liegt senkrecht zu der X-und der Y-Richtung, also in Z-Richtung. Die Substrataufnahme 14 hat damit in X- und Y-Richtung, also in einer mit dem X-Y-Koordinatensystem zusammenfallenden Substratebene, zwei Freiheitsgrade über eine Translationseinheit. Auf der Translationseinheit befindet sich eine Rotationseinheit mit einem Freiheitsgrad in Rotationsrichtung. Die Substrataufnahme 14 ist nach Fixierung auf der Translationseinheit und der Rotationseinheit fix mit diesen verbunden, so dass ein Fehler durch Änderung der Relativposition der Substrataufnahme 14 während der Ausführung der erfindungsgemäßen Verfahren ausgeschlossen wird. Die X-Y-Position der Rotationsachse 12 der Substrataufnahme 14 ist also systemimmanent konstant zur Translations- und Rotationseinheit, ebenso wie eine auf der Substrataufnahme 14 vorgesehene Referenzmarkierung 10 und ein auf der Substrataufnahme 14 fixierter Wafer 3.

Oberhalb der Substrataufnahme 14 ist ein erstes Objektiv 8 fixiert, dessen optische Achse 11 in Z-Richtung verläuft, also parallel zur Rotationsachse 12. Das Objektiv 8 ist auf die Oberseite 2 des Wafers 3 und/oder die Oberfläche 9 der Substrataufnahme 14 sowie auf die Oberseite 2 fokussierbar und das Objektiv 8 ist in der Lage, Strukturen auf der Oberseite 2 und/oder der Oberfläche 9 zu erkennen, zu erfassen und als X-Y-Wert an eine nicht dargestellte Datenverarbeitungseinrichtung weiterzugeben. Da die Position des Objektives 8 und damit der optischen Achse 11 fix ist, kann mittels des Objektivs 8 die Position von optischen Markierungen, insbesondere eine Referenzmarkierung 10 der Substrataufnahme 14, vorzugsweise an deren Oberfläche 9, erfasst und an eine Datenverarbeitungseinrichtung zur Auswertung weitergegeben werden.

In der in Figur 3a und 3b gezeigten Ausführungsform ist an der Oberfläche 9 der Substrataufnahme 14 eine Referenzmarkierung 10 angebracht, deren Position an der Substrataufnahme 14 zumindest näherungsweise bekannt ist und die entsprechend schnell durch die Translationseinheit angefahren werden kann, um von dem Objektiv 8 erfasst zu werden.

Gegenüberliegend zu dem Objektiv 8 ist ein weiteres Objektiv 15 zur Erfassung von optischen Markierungen oder Kontaktstellen 5 auf der Unterseite 7 des Wafers 3 analog dem Objektiv 8 angeordnet, wobei eine optische Achse des Objektivs 15 in etwa in Flucht mit der optischen Achse 11 des Objektivs 8 ist. Das zweite Objektiv 15 dient zumindest überwiegend oder ausschließlich dazu, die X-Y-Position der zu Kontaktstellen 4 korrespondierenden Kontaktstellen 5 im X-Y-Koordinatensystem bzw. in der dazu parallelen Ebene der Unterseite 7 zu erfassen, um den Ausrichtungsfehler der Kontaktstellen 5, insbesondere zu den Kontaktstellen 4 durch die Datenverarbeitungseinrichtung, insbesondere durch Vektorberechnung, ermitteln zu können.

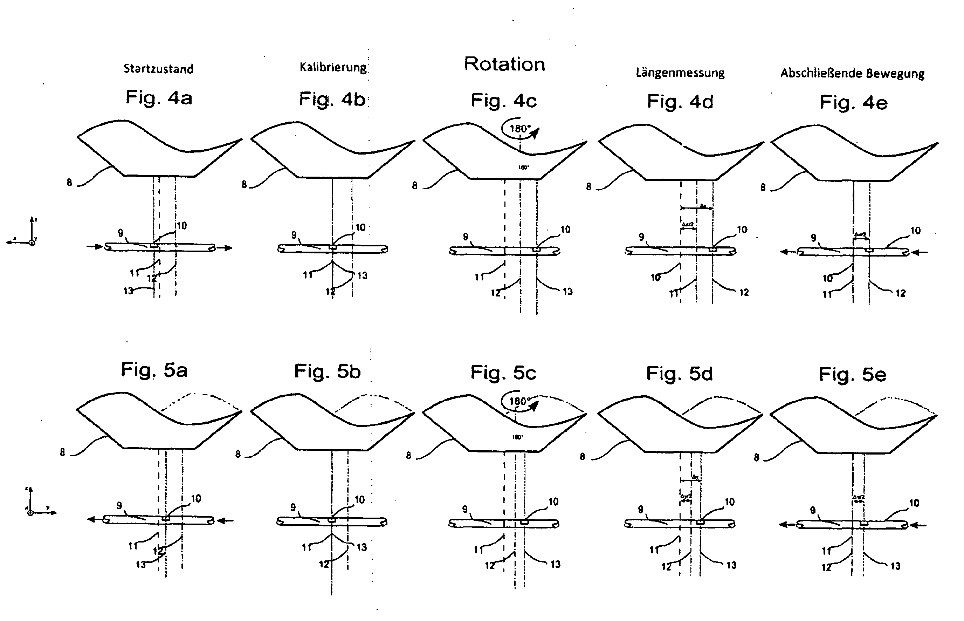

Zur Bestimmung beziehungsweise Ermittlung der X-Y-Position der Rotationsachse 12 wird zunächst eine Seite der Substrataufnahme 14, nachfolgend die Oberfläche 9, ausgewählt und gemäß Figur 4a und Figur 5a wird Substrataufnahme 14 durch die Translationseinheit in X- und Y-Richtung verfahren, bis die Referenzmarkierung 10 von einer X-Y-Ausgangsposition 13 in der optischen Achse 11 des Objektivs 8 liegt. Die X-Y-Position der Referenzmarkierung 10 an dieser Stelle wird in der Datenverarbeitungseinrichtung als erste X-Y-Referenzposition RP gespeichert. Die Substrataufnahme 14 wird anschließend durch die Rotationseinheit um einen Rotationswinkel von 180 Grad in eine zweite Rotationslage gedreht, und zwar um die Rotationsachse 12, so dass die Referenzmarkierung 10 nunmehr in einer gegenüber der vorherigen, ersten X-Y-Referenzposition RP gemäß Figur 4c genau gegenüberliegend der Rotationsachse 12, also gespiegelt zur Rotationsachse 12, liegenden, zweiten X-Y-Referenzposition RP' angeordnet ist. Die Figuren Fig. 4d und 5d zeigen dann, dass der Abstand der Rotationsachse 12 zur optischen Achse 11 in X-bzw. Y-Richtung die Hälfte des Abstandes zwischen der alten und neuen Position der Referenzmarkierung 10 in X- bzw. Y-Richtung ist. Anschließend kann man, gemäß Fig. 4e und 5e, die Substrataufnahme 14 durch die Translationseinheit in X- und Y-Richtung so verfahren, dass die Referenzmarkierung 10 wieder im Fokus des Objektivs 8 und schließlich genau in der optischen Achse 11 liegt. Man benötigt diesen Schritt bei der Kalibrierung nicht unbedingt, da ja die Distanz schon aus 4d und 5d bekannt ist, der "Nullpunkt" kann also schon in der Software gesetzt werden. Durch das Ermitteln der X-Y-Position in der um 180 Grad gedrehten Rotationslage ist die zwischen der ersten und zweiten X-Y-Referenzposition RP, RP' liegende X-Y-Position der Rotationsachse 12 durch die Datenverarbeitungseinrichtung mittels Vektorrechnung ermittelbar, beispielsweise durch Messung des von der Translationseinheit zurückgelegten Weges in X- und Y-Richtung beim Verfahren der Substrataufnahme 14. Der somit berechnete Wert für die X-Y-Position der Rotationsachse 12 dient anschließend zumindest für die Dauer der Bestimmung des Ausrichtungsfehlers der Vielzahl von Kontaktstellen 4, 5 auf dem jeweiligen, auf der Substrataufnahme 14 fixierten Wafer 3 als Referenzwert für die Berechnung des Ausrichtungsfehlers. Erst beim Aufbringen/Fixieren eines neuen Wafers 3 auf der Substrataufnahme 14 oder erst beim Einsetzen einer neuen Substrataufnahme 14 muss die Bestimmung der X-Y-Position der Rotationsachse 12 im Sinne einer neuen Kalibrierung der Anlage auf die neue Substrataufnahme 14 erneut durchgeführt werden.

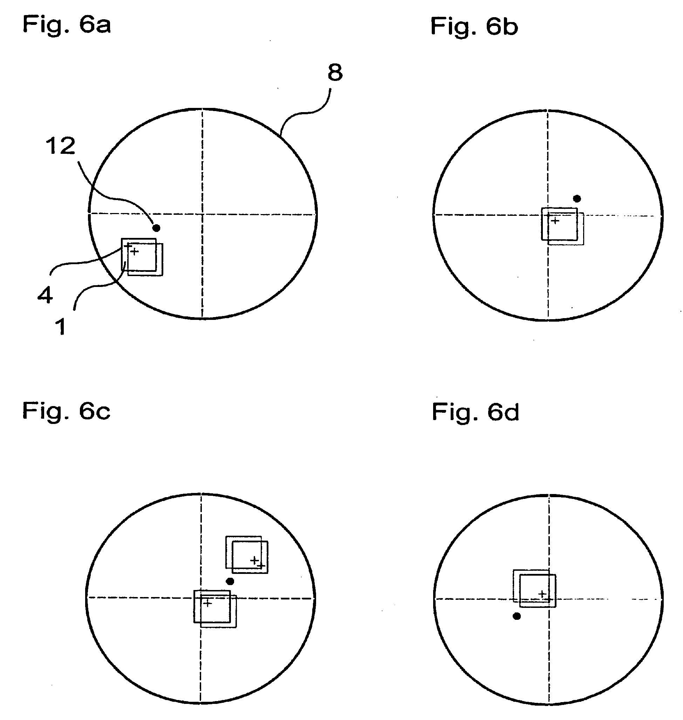

Zur in den Figuren 6a bis 6d gezeigten Bestimmung beziehungsweise Ermittlung des Ausrichtungsfehlers der Kontaktstelle 4 zur Kontaktstelle 5 wird zunächst eine Seite des Wafers 3, nachfolgend die Oberseite 2, ausgewählt und gemäß Figur 4a und Figur 5a wird der Wafer 3 durch die Substrataufnahme 14 verfahren, bis die Kontaktstelle 4 in der optischen Achse 11 des Objektivs 8 liegt (Fig. 6b). Gleichzeitig oder unmittelbar anschließend wird die Position der Kontaktstelle 5 an der gegenüberliegenden Seite, also der Unterseite 7, mit dem unteren Objektiv 15 bestimmt. Die Substrataufnahme 14 wird um einen Rotationswinkel von 180 Grad gedreht, und zwar um die Rotationsachse 12, so dass die Kontaktstellen 4, 5 nunmehr in einer gegenüber der vorherigen, ersten Rotationsposition gemäß Figur 4d genau gegenüberliegend der Rotationsachse 12, also gespiegelt zur Rotationsachse 12, angeordnet sind (Fig. 6c). Anschließend wird der Wafer 3 durch die Substrataufnahme 14 so verfahren, dass die zuvor ausgewählte Kontaktstelle 4 wieder im Fokus des Objektivs 8 liegt (Fig. 6d). Durch das erneute Ermitteln der Position der gegenüberliegenden Kontaktstelle 5 an der um 180 Grad gedrehten Rotationslage ist der doppelte Ausrichtungsfehler durch die Datenverarbeitungseinrichtung ermittelbar, und nach Division durch 2 der entsprechende Ausrichtungsfehler zwischen den Kontaktstellen 4 und 5.

Durch das erfindungsgemäße Verfahren wird der Vorgang des Zurückfahrens der Kontaktstelle 4 nach der Rotation des Substrats um 180 Grad in den Fokus des Objektivs 8 stark beschleunigt, da aufgrund der unterschiedlichen Ausgestaltung der Substrate und der Ablage der Substrate auf der Substrataufnahme bisher eine genaue Positionierung der Kontaktstelle 4 nach der 180°-Drehung nur durch ein sogenanntes Pre-Alignment möglich war. Das bedeutet, dass nach der Drehung die Kontaktstelle 4 erst wieder in dem Bildkoordinatensystem des Objektivs 8 zentriert werden musste, bevor an der gegenüberliegenden Seite der Oberseite 7 die Position der korrespondierenden Kontaktstelle 5 gemessen werden konnte.

Durch die in Figuren 3a bis 5e gezeigte Bestimmung der Position der Rotationsachse 12 in dem, hier zum Objektiv 8 fixen X-Y-Koordinatensystem in der Substratebene, nämlich in X- und Y-Richtung, kann auf das Pre-Alignment verzichtet werden, da die genaue X-Y-Position der Kontaktstelle 4 nach der 180°-Drehung des Wafers 3 durch die Substrataufnahme 14 bekannt ist und direkt angefahren werden kann.

Gemäß einer besonderen Ausführungsform der Erfindung ist es erfindungsgemäß denkbar, zunächst alle an der Oberseite 2 und Unterseite 7 verteilten Kontaktstellen 4 und 5 in der ersten Rotationslage zu messen und anschließend, nach einmaliger Drehung um 180 Grad die Position der Kontaktstellen 4 und 5 in der zweiten Rotationslage nacheinander zu messen, da die jeweiligen Positionen der korrespondierenden Kontaktstellen 4, 5 in der ersten Rotationslage in einem Speicher der Auswerteeinheit gespeichert werden. Hierdurch ist eine weitere, beträchtliche Beschleunigung des erfindungsgemäßen Verfahrens möglich.

Die Ermittlung der Position der Rotationsachse 12 läuft alternativ wie folgt ab:
- in Figur 4a wird statt der Referenzmarkierung 10 eine auf dem Wafer 3 also auf der Oberseite 2 des Wafers 3 angeordnete Kontaktstelle 4 als Referenzmarkierung von der in Figur 4a gezeigten Position, also außerhalb der Rotationsachse 12 und außerhalb der optischen Achse 11 in X-Richtung (siehe Figur 4b) und in Y-Richtung (siehe Figur 5b) so weit verfahren, dass die als Referenzmarkierung dienende Kontaktstelle 4 genau in der optischen Achse 11 des Objektivs 8 liegt.
- die Position der Kontaktstelle 4 wird als X-Y-Referenzposition RP gespeichert, und zwar als X-Y-Position in dem durch die X- und die Y-Richtung vorgegebenen X-Y-Koordinatensystem.
- Drehung der Substrataufnahme 14 und damit des auf der Substrataufnahme 14 fixierten Wafers 3 mit seiner als Referenzmarkierung dienenden Kontaktstelle 4 um 180 Grad (siehe Figur 4c). Die Drehung erfolgt um die Rotationsachse 12, so dass die Kontaktstelle 4 gemäß Figur 4d und Figur 5d zu der Rotationsachse 12 gespiegelt zu der ersten X-Y-Referenzposition RP in einer zweiten X-Y-Referenzposition RP' liegt. Gespiegelt zu der Rotationsachse 12 bedeutet gespiegelt zu dem Schnittpunkt der Rotationsachse 12 mit dem X-Y-Koordinatensystem beziehungsweise der Substratebene.
- Die Substrataufnahme 14 wird gemäß Figuren 4e und 5e durch die Translationseinheit beziehungsweise den Translationsantrieb in X- und Y-Richtung so weit bewegt, bis die Referenzmarkierung (Kontaktstelle 4) wieder in der optischen Achse 11 liegt. Die Bewegung der Substrataufnahme 14 durch die Translationseinheit wird genau gemessen/erfasst und an die Datenverarbeitungseinrichtung weitergegeben, so dass aus der ersten X-Y-Referenzposition RP und der zweiten X-Y-Referenzposition RP' die genaue X-Y-Position der Rotationsachse 12, nämlich jeweils die halbe Strecke in X- und Y-Richtung, beispielsweise durch Vektorberechnung, ermittelt wird. Die hierdurch ermittelte X-Y-Position entspricht der X-Y-Position der Rotationsachse 12 im Schnittpunkt mit der Substratebene beziehungsweise dem X-Y-Koordinatensystem.

### Verfahren zur Bestimmung der Position einer Rotationsachse

### Bezugszeichenliste

- 1: Halbleiterbauelement
- 2: Oberseite
- 3: Wafer
- 4: Kontaktstelle
- 5: Kontaktstelle
- 6: Halbleiterbauelement
- 7: Unterseite
- 8: Objektiv
- 9: Oberfläche
- 10: Referenzmarkierung
- 11: optische Achse
- 12: Rotationsachse
- 13: X-Y-Ausgangsposition
- 14: Substrataufnahme
- 15: Objektiv
- R: Rotationswinkel

## Patentansprüche

1. Verfahren zur Bestimmung einer in einem X-Y-Koordinatensystem liegenden X-Y-Position einer senkrecht zu dem X-Y-Koordinatensystem liegenden Rotationsachse (12) einer um die Rotationsachse (12) rotierbaren Substrataufnahme (14) zur Aufnahme eines Substrats (3) sowie Bestimmung eines Ausrichtungsfehlers von Kontaktstellen des Substrats (3) mit folgenden Schritten:
- Bestimmung einer ersten X-Y-Referenzposition RP einer an der Substrataufnahme (14) vorgesehenen Referenzmarkierung (10),
- Rotation der Substrataufnahme (14) um einen definierten Rotationswinkel R um die Rotationsachse (12),
- Bestimmung einer zweiten, durch die Rotation geänderten X-Y-Referenzposition RP' der Referenzmarkierung (10),
- Berechnung der Position der Rotationsachse (12) in der Substratebene,
- Bestimmung des Ausrichtungsfehlers von Kontaktstellen des Substrats (3), wobei das Substrat auf der Substrataufnahme während der Bestimmung des Ausrichtungsfehlers der Kontaktstellen fixiert ist,
**dadurch gekennzeichnet, dass** das Substrat (3) auf der Substrataufnahme auch (14) während der Bestimmung der Position der Rotationsachse fixiert ist.

2. Verfahren nach Anspruch 1, **dadurch gekennzeichnet, dass** die Rotation des Substrats (3) oder der Substrataufnahme (14) um die Rotationsachse (12) durch Rotationsmittel der Substrataufnahme (14) erfolgt.

3. Verfahren nach einem der vorhergehenden Ansprüche, **dadurch gekennzeichnet, dass** die Bestimmung der ersten RP und zweiten Referenzposition RP' durch optische Positionserfassungsmittel, insbesondere mindestens ein Objektiv (8, 15) umfassend, vorzugsweise mit einer optischen Achse (11) parallel zur Rotationsachse (12), erfolgt.

4. Verfahren nach einem der vorhergehenden Ansprüche, **dadurch gekennzeichnet, dass** die Substrataufnahme (14) relativ zu den optischen Positionserfassungsmitteln in dem oder parallel zu dem X-X-Koordinatensystem bewegbar ist, wobei die Relativbewegung X-und Y-Richtung im X-Y-Koordinatensystem erfassbar ist.

## Claims

1. Method for determining an X-Y position, in an X-Y coordinate system, of an axis of rotation (12), which is perpendicular to the X-Y coordinate system, of a substrate holding means (14) that can rotate around the axis of rotation (12) for holding a substrate (3) and for determining an alignment error of contact points of the substrate (3) with the following steps:
- Determining a first X-Y reference position RP of a reference labeling (10) that is provided on the substrate holding means (14),
- Rotating the substrate holding means (14) by a defined angle of rotation R around the axis of rotation (12),
- Determining a second X-Y reference position RP' of the reference labeling (10) that is changed by the rotation,
- Calculating the position of the axis of rotation (12) in the substrate plane,
- Determining the alignment error of contact points of the substrate (3), wherein the substrate is fixed on the substrate holding means (14) during the determination of the alignment error,
**characterized in that** the substrate (3) is also fixed during the determination of the position of the axis of rotation.

2. Method according to Claims 1, **characterized in that** the rotation of the substrate (3) or the substrate holding means (14) around the axis of rotation (12) is carried out by rotation means of the substrate holding means (14).

3. Method according to one of the preceding claims, **characterized in that** the determination of the first RP and the second reference position RP' is effected by optical positional detecting means which in particular comprise at least one lens (8, 15) preferably with an optical axis (11) that is parallel to the axis of rotation (12).

4. Method according to one of the preceding claims, wherein the substrate holding means (14) can be moved relative to the optical positional detecting means in the X-Y coordinate system or parallel to the X-Y coordinate system, whereby the relative movement can be detected in the X- and Y-directions in the X-Y coordinate system.

## Revendications

1. Procédé de définition d'une position X-Y se situant dans un système de coordonnées X-Y d'un axe de rotation (12) placé perpendiculairement au système de coordonnées X-Y d'un support de substrat (14) pouvant tourner autour de l'axe de rotation (12) et destiné à recevoir un substrat (3) et de définition d'une erreur d'alignement de points de contact du substrat (3), comportant les étapes suivantes :
- définition d'une première position de référence X-Y RP d'un marquage de référence (10) apposé sur le support de substrat (14),
- rotation du support de substrat (14) à raison d'un angle de rotation défini R autour de l'axe de rotation (12),
- définition d'une seconde position de référence X-Y modifiée RP' du marquage de référence (10),
- calcul de la position de l'axe de rotation (12) dans le plan du substrat,
- définition de l'erreur d'alignement de points de contact du substrat (3), le substrat étant fixé sur le support de substrat pendant la définition de l'erreur d'alignement des points de contact,
**caractérisé en ce que** le substrat (3) est également fixé sur le support de substrat (14) pendant la définition de la position de l'axe de rotation.

2. Procédé selon la revendication 1, **caractérisé en ce que** la rotation du substrat (3) ou du support de substrat (14) autour de l'axe de rotation (12) se fait grâce à des moyens de rotation du support de substrat (14).

3. Procédé selon une des revendications précédentes, **caractérisé en ce que** la définition de la première position de référence RP et de la seconde RP' se fait grâce à des moyens optiques de détection de position, en particulier comprenant au moins un objectif (8, 15) ayant de préférence un axe optique (11) parallèle à l'axe de rotation (12).

4. Procédé selon une des revendications précédentes, **caractérisé en ce que** le support de substrat (14) est mobile par rapport aux moyens optiques de détection de position dans le ou parallèlement au système de coordonnées X-Y, le mouvement relatif dans le sens x et Y étant détectable dans le système de coordonnées X-Y.
